# FASCICULE DE BREVET EUROPEEN

(11) **EP 2 294 498 B1**
(45) Date de publication et mention de la délivrance du brevet: **08.07.2015**
(21) Numéro de dépôt: 09769488.9
(22) Date de dépôt: 28.05.2009
(51) Int. Cl.: G06F 1/20, H05K 7/20

(54) **DISPOSITIF DE REFROIDISSEMENT D'UNE BAIE INFORMATIQUE ET INSTALLATION INFORMATIQUE COMPORTANT UN TEL DISPOSITIF**
COMPUTERBAY-KÜHLEINRICHTUNG UND COMPUTERGERÄT DAMIT
COMPUTER BAY COOLING DEVICE AND COMPUTER EQUIPMENT COMPRISING SAME

(30) Priorité: 02.06.2008 FR 0803013
(43) Date de publication de la demande: 16.03.2011
(73) Titulaire: Bull S.A.S., 78340 Les Clayes-sous-Bois (FR)
(72) Inventeur: JULIEN-ROUX, Audrey, F-78300 Poissy (FR); COUTANCIER, Lionel, F-28210 Croisilles (FR); FROMONT, Thierry, F-91300 Massy (FR)
(74) Mandataire: Bonnet, Michel
(86) Numéro de dépôt international: PCT/FR2009/050998
(87) Numéro de publication internationale: WO 2009/156647

(56) Documents cités:
- US-A1- 2001 042 616
- US-A1- 2004 100 770
- US-A1- 2007 171 613
- US-B1- 6 819 563

## Description

La présente invention concerne un dispositif de refroidissement d'une baie informatique et une installation informatique comportant un tel dispositif.

Une baie informatique est une structure matérielle dans laquelle sont disposés des équipements informatiques (calculateurs, dispositifs de stockage, etc.), généralement repérés par leur positionnement vertical dans la baie. Une unité U standard a ainsi été définie par la norme EIA-310-D pour définir ce repérage de façon universelle : 1 U = 44,45 mm.

Les équipements informatiques d'une baie comportent des composants électriques de puissance dont le fonctionnement génère une dissipation de chaleur qu'il convient d'évacuer. Bien que l'apparition des technologies CMOS ait permis de diminuer la puissance dissipée des composants et d'augmenter leur capacité d'intégration sur une même puce, les applications demandent parallèlement toujours plus de puissance de calcul (gestion de bases de données, applications décisionnelles, calcul intensif, accès Internet, etc.).

Ainsi, les techniques de conception d'ordinateurs à architecture multiprocesseurs symétrique (architecture SMP, de l'anglais « Symmetric MultiProcessing ») et les techniques de groupement d'ordinateurs en grappes de serveurs permettent de répondre à ce besoin de puissance. Il est alors possible de concevoir des calculateurs de type HPC (de l'anglais « High Performance Computing »), pouvant intégrer jusqu'à dix mille processeurs élémentaires à fréquences d'horloge très élevées, répartis en un grand nombre de serveurs de calculs disposés dans plusieurs baies, elles-mêmes installées et interconnectées entre elles dans une salle informatique fermée et climatisée dans laquelle on tente toujours d'incorporer un maximum de serveurs dans les trois dimensions. L'objectif est d'atteindre un maximum de Giga Flops (de l'anglais « Floating-point Opérations Per Second ») par m² et/ou le maximum de connexions Internet par m².

Or dans le même temps, l'utilisation de technologies de plus en plus fines pour la réalisation des transistors et la course aux fréquences élevées ont conduit à l'augmentation des courants de fuite des transistors et à une explosion de puissance dissipée par chaque processeur qui peut atteindre aujourd'hui 185 Watts. Ainsi, remplir une salle informatique se heurte nécessairement à la première limite atteinte parmi les trois suivantes : sa capacité en volume, sa capacité en alimentation électrique et sa capacité à évacuer les calories générées.

L'évacuation des calories générées par une climatisation de la salle informatique pose des problèmes de coûts importants : coûts liés à la consommation électrique du système de climatisation, mais également ceux liés à son installation et à sa maintenance.

Par ailleurs, une salle informatique comporte généralement un faux-plancher constitué de dalles carrées de dimensions 60 cm x 60 cm, sur lesquelles sont disposées les baies informatiques et sous lesquelles circulent des câbles de raccordement électrique. Une baie informatique standard a une hauteur comprenant généralement 42 U utiles, une largeur égale à celle d'une dalle et une profondeur variable, mais généralement comprise entre une et deux dalles. En outre, d'un point de vue de maintenance et de câblage, il est nécessaire d'avoir accès au faux-plancher sous la baie informatique, de sorte que la dalle devant la face avant de la baie et celle devant sa face arrière doivent être libres d'accès. Ainsi la surface au sol d'une baie informatique nécessaire pour une salle informatique est en fait de quatre dalles, ce qui représente la référence standard. C'est pourquoi la profondeur d'une baie informatique ne doit pas dépasser deux dalles, tout empiètement sur une dalle « de maintenance » la condamnant.

Au vu de ce qui précède, le rapport de densité maximale possible avec du matériel standard dans une salle informatique est donc de 42 U/1,44m² ce qui donne un rapport de 29 U/m², dans l'hypothèse où l'intégralité de l'espace intérieur des baies informatiques de la salle est utilisée. A partir de ce rapport de densité, on peut estimer le rapport de dissipation thermique par surface au sol de salle, qui régit thermiquement la capacité de refroidissement d'une salle en tenant compte des critères de fonctionnement du matériel informatique (i.e. limite en température d'entrée d'air dans le matériel).

Une solution de refroidissement est fondée sur le fait que les équipements informatiques disposés dans la baie sont auto ventilés et refroidis ainsi, grâce à la climatisation de la salle informatique. Le circuit de refroidissement est donc le suivant : l'air frais fourni par la climatisation de la salle entre dans la baie via une porte avant ayant un certain pourcentage d'ouverture, s'échauffe en passant à travers les équipements informatiques et est rejeté de la baie via une porte arrière dans la salle avec une température de sortie plus élevée, parfois de plusieurs dizaines de degrés selon les appareils. Comme chaque équipement informatique ne peut fonctionner que dans une tranche de températures d'entrée d'air, la climatisation de la salle doit réguler la température ambiante de façon suffisante pour rester dans cette tranche.

Sachant qu'une climatisation performante permet de refroidir des baies informatiques qui dissipent jusqu'à 10 ou 12 kW, cela donne un rapport de dissipation thermique de 7 à 8 kW/m². Si l'on tient compte de la charge thermique actuelle d'un serveur qui est comprise entre 750 W et 1 kW par U, on obtient un rapport de dissipation thermique compris entre 7 et 10 U/m² et donc la salle, qui a une capacité théorique de 29 U/m², peut refroidir les baies informatiques à condition qu'elles soient remplies d'un taux compris entre 24 et 34 %.

Autrement dit, pour qu'une salle informatique soit correctement refroidie à l'air, elle ne doit être constituée que de baies aux 2/3 ou 3/4 vides. Par conséquent, le rendement économique est faible en terme de surface au sol, en terme de câblage (longueur, distance), ainsi qu'en terme de consommation électrique du système de climatisation qui devra en outre prendre en charge le manque d'homogénéité de la température ambiante de la salle si les équipements sont mixtes.

Une autre solution de refroidissement consiste à réduire le problème thermique à l'espace de la baie, c'est-à-dire à prévoir des moyens de refroidissement dans la baie informatique elle-même. Ces moyens de refroidissement comportent par exemple un échangeur de chaleur air/eau. Le circuit de refroidissement est donc le suivant : l'air frais fourni par la climatisation de la salle entre dans la baie, s'échauffe en passant à travers les équipements informatiques et est refroidi par l'échangeur de chaleur air/eau installé dans la baie, ce dernier permettant de transférer les calories de l'air à l'eau de l'échangeur qui est réinjectée dans un circuit hydraulique de la salle et est refroidie au niveau de groupes froids. Cette solution est avantageuse parce que le pouvoir caloporteur de l'eau est d'environ 4000 fois supérieur à celui de l'air.

Cependant les moyens de refroidissement propres à chaque baie informatique prennent de la place et le choix de leur emplacement est important.

Par exemple, une première variante consiste à disposer ces moyens de refroidissement latéralement dans la baie. L'inconvénient de cette variante est que pour les intégrer dans le flanc de la baie, il faut augmenter la dimension de la baie en largeur. Elle ne correspond alors plus à une dalle en largeur, mais au minimum une dalle et 1/3 de dalle supplémentaire. Si l'on recalcule le rapport U/m², on observe une diminution à 22 U/m², ce qui donne un rapport de dissipation thermique de 16,5 à 22 kW/m², inférieur aux rapports calculés dans des conditions optimales.

Une seconde variante consiste à disposer ces moyens de refroidissement en bas dans la baie. L'inconvénient de cette variante est que pour les intégrer ainsi, il faut leur réserver une certaine hauteur et donc réduire la capacité d'intégration verticale d'équipements informatiques de la baie. De même que précédemment, si l'on recalcule le rapport U/m², on observe une diminution à 23,6 U/m², ce qui donne un rapport de dissipation thermique de 17,5 à 23,6 kW/m², toujours inférieur aux rapports calculés dans des conditions optimales.

En fait, il apparaît que la meilleure solution est de disposer ces moyens de refroidissement à l'arrière de la baie informatique, au niveau de sa porte arrière, dans un espace disponible du fait que les baies informatiques ont une profondeur inférieure à deux dalles.

L'invention s'applique donc plus particulièrement à un dispositif de refroidissement d'une baie informatique munie d'une face arrière comportant une zone d'évacuation, vers l'extérieur de la baie, d'air ayant circulé sur des composants électriques de puissance disposés à l'intérieur de cette baie informatique, comportant une porte arrière dans l'épaisseur de laquelle sont disposés des moyens de refroidissement d'air.

Un tel dispositif est décrit dans le document publié sous le numéro US 2006/0232945. Dans ce document, les moyens de refroidissement de la baie informatique comportent un échangeur de chaleur air/eau intégré dans l'épaisseur de la porte arrière d'une baie informatique. La porte arrière est montée sur le châssis de la baie informatique. Mais elle impose un châssis spécifique différent d'un châssis de baie classique ne comportant pas de moyens propres de refroidissement. En outre, si la porte arrière devait comporter également un système de ventilation, elle serait encore plus lourde et/ou encombrante et une structure différente de châssis devrait encore être conçue.

Il apparaît ainsi qu'une baie destinée initialement à recevoir du matériel peu dissipatif devrait être remplacée par une autre baie telle que celle décrite dans le document précité si le matériel qu'elle comporte évoluait et devenait plus dissipatif. Or une salle informatique est amenée à évoluer au cours du temps : être obligé, soit de modifier le système de climatisation, soit de remplacer les baies informatiques selon la variation des besoins, est contraignant. Il est en outre important de pouvoir conserver une mixité des équipements dans une salle sans pour autant nuire à l'homogénéité thermique de la salle, ce qui n'est pas simple à assurer avec les baies précitées.

Par ailleurs, les documents US 6,819,563 B1 et US 2004/0100770 A1 divulguent chacun un dispositif de refroidissement d'une baie informatique munie d'une face arrière comportant une zone d'évacuation, vers l'extérieur de la baie, d'air ayant circulé sur des composants électriques de puissance disposés à l'intérieur de cette baie informatique, comportant une porte arrière dans l'épaisseur de laquelle sont disposés des moyens de refroidissement d'air incluant au moins un échangeur de chaleur air/eau, comportant en outre des premiers moyens de raccordement à une alimentation externe en eau froide et des seconds moyens de raccordement à une évacuation externe d'eau chaude ayant circulé dans l'échangeur de chaleur air/eau.

Il peut être souhaité de prévoir un dispositif de refroidissement de baie informatique qui permette de s'affranchir d'au moins une partie des problèmes et contraintes précités.

L'invention a donc pour objet un dispositif de refroidissement tel que défini dans la revendication 1.

Ainsi, si une baie informatique à échangeur de chaleur air/eau doit être adaptée pour inclure des moyens de refroidissement ou pour remplacer ses moyens de refroidissement par des moyens de refroidissement plus performants, grâce à un dispositif de refroidissement selon l'invention qui a la particularité d'être interchangeable à l'aide de ses moyens de positionnement amovible, il n'est pas nécessaire de remplacer intégralement la baie : il suffit d'ôter sa porte arrière et de positionner le nouveau dispositif de refroidissement contre sa face arrière. Plus généralement, l'interchangeabilité des dispositifs de refroidissement sur une même structure commune de baie informatique facilite la gestion de l'évolution d'une salle informatique et le maintien d'une homogénéité de température au cours du temps. En outre, le problème de l'encombrement des moyens de raccordements de l'échangeur de chaleur air/eau est résolu par la fixation du plateau en partie inférieure du cadre porteur.

De façon optionnelle, le cadre porteur comporte des moyens autonomes d'appui au sol, distincts de ceux de la baie informatique.

Dans ce cas, même si la porte arrière est lourde et/ou encombrante du fait qu'elle contient des moyens de refroidissement plus puissants, il n'est pas nécessaire pour autant d'adapter la structure de la baie informatique contre laquelle elle est positionnée puisqu'elle est intégralement portée par le cadre porteur via ses propres moyens d'appui.

De façon optionnelle également, la porte arrière est montée pivotante sur le cadre porteur à l'aide d'une charnière dont l'axe de rotation vertical est situé sur une face extérieure du cadre porteur et de la porte arrière, du côté de l'ouverture de la porte.

De façon optionnelle également, les dispositifs de raccordement à l'alimentation externe et à l'évacuation externe sont disposés sur le cadre porteur et les dispositifs de raccordement pivotant à l'échangeur de chaleur air/eau sont disposés dans la porte arrière.

De façon optionnelle également, le plateau de réception est à au moins deux supports horizontaux superposés.

De façon optionnelle également, des moyens de guidage des tuyaux flexibles, notamment des pions de guidage, sont disposés dans le plateau de réception.

De façon optionnelle également, les moyens de refroidissement d'air disposés dans l'épaisseur de la porte arrière comportent une pluralité de ventilateurs pour attirer l'air ayant circulé sur les composants électriques de puissance vers l'extérieur de la baie informatique.

Enfin, l'invention a également pour objet une Installation informatique comportant une baie informatique munie d'une face arrière comportant une zone d'évacuation, vers l'extérieur de la baie, d'air ayant circulé à travers des composants électriques de puissance disposés à l'intérieur de cette baie informatique, et un dispositif de refroidissement tel que défini précédemment.

L'invention sera mieux comprise à l'aide de la description qui va suivre, donnée uniquement à titre d'exemple et faite en se référant aux dessins annexés dans lesquels :
- la figure 1 représente schématiquement et en vue latérale une installation informatique selon un mode de réalisation de l'invention,
- la figure 2 représente schématiquement et en vue de dessus l'installation de la figure 1,
- les figures 3a et 3b représentent en vue de dessus et en coupe un dispositif de refroidissement selon un mode de réalisation de l'invention dans deux positions différentes d'une porte arrière,
- la figure 4 est une vue en perspective d'un dispositif de raccordement pivotant mis en oeuvre dans le dispositif des figures 3a et 3b,
- la figure 5 représente en vue de dessus et en coupe un dispositif de refroidissement selon un autre mode de réalisation de l'invention, et
- la figure 6 est une vue en perspective d'un plateau de réception et de guidage mis en oeuvre dans le dispositif de la figure 5.

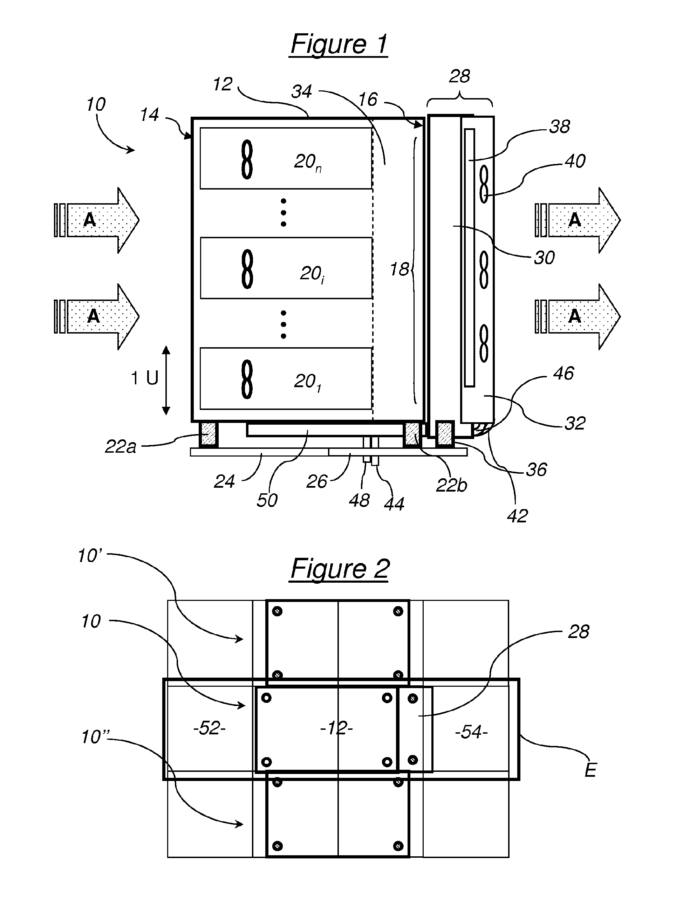

L'installation informatique 10 représentée sur la figure 1 comporte une baie informatique 12 munie d'une face avant 14 et d'une face arrière 16. La face avant 14 comporte par exemple une porte avant (non représentée) ayant un certain pourcentage d'ouverture. La face arrière 16 comporte une zone d'évacuation 18, vers l'extérieur de la baie informatique 12, d'une quantité d'air ayant circulé à travers des équipements informatiques auto ventilés 20₁, ... 20ᵢ, ..., 20ₙ disposés verticalement à l'intérieur de la baie 12 et repérés en position selon l'unité standard U. Les équipements informatiques auto ventilés 20₁, ... 20ᵢ, ..., 20ₙ comportent des composants électriques de puissance consommateurs d'énergie électrique et émetteurs de chaleur, de sorte que l'air se réchauffe en les traversant.

La baie informatique 12 comporte des moyens 22a, 22b d'appui au sol. Ces moyens d'appui 22a, 22b sont par exemple quatre pieds à vérins, disposés sur deux dalles 24 et 26 d'une salle informatique dans laquelle se trouve l'installation 10. Deux pieds à vérins avant 22a de la baie informatique 12 sont disposés sur la première dalle 24 et deux pieds à vérins arrière 22b de la baie informatique 12 sont disposés sur la seconde dalle 26.

L'installation informatique 10 comporte en outre un dispositif de refroidissement 28 positionné contre la face arrière 16 de la baie 12. Ce dispositif de refroidissement 28 comporte un cadre porteur 30 sur lequel une porte arrière 32 est montée. Des moyens de refroidissement d'air sont prévus dans l'épaisseur de cette porte arrière 32.

Le cadre porteur 30 est conformé pour pouvoir entourer la zone d'évacuation d'air 18 de sorte que toute la quantité d'air qui traverse cette zone d'évacuation 18 est amenée à passer à travers la porte arrière 32 du cadre porteur 30 et à être refroidie par celle-ci. Le circuit de refroidissement de l'air est donc le suivant, repéré par les flèches A : l'air frais fourni par la climatisation de la salle entre dans la baie informatique 12 via la face avant 14, s'échauffe en passant à travers les équipements informatiques auto ventilés 20₁, ... 20ᵢ, ..., 20ₙ, passe à travers un espace de câblage 34 situé entre l'arrière des équipements informatiques 20₁, ... 20ᵢ, ..., 20ₙ et la zone d'évacuation 18, et est rejeté hors de la baie 12 via le dispositif de refroidissement 28 dans la salle avec une température de sortie pouvant être égale à la température d'entrée dans la baie 12, ce qui rend cette dernière thermiquement transparente. L'économie réalisée en climatisation de la salle informatique est par conséquent très sensible.

Le cadre porteur 30 comporte des moyens de positionnement amovible contre la face arrière 16 de la baie informatique 12. De façon classique, ces moyens de positionnement amovible peuvent comporter des moyens (non représentés) de réglage du positionnement exact du cadre porteur 30 contre la face arrière 16 de la baie informatique 12 : ces moyens de réglage sont par exemple des formes en relief aménagées sur le cadre porteur 30 et se positionnant face à des formes en relief correspondantes aménagées sur la face arrière 16 de la baie informatique 12. Ils peuvent en outre comporter un bord rabattu destiné à entourer la périphérie extérieure de la face arrière 16 de la baie 12. Ils sont éventuellement associés à des moyens de fixation amovible classiques (systèmes à vis, encliquetage, etc.) pour assurer le maintien du cadre porteur 30 contre la face arrière 16.

En outre, les moyens de positionnement amovible du cadre porteur 30 peuvent comporter des moyens autonomes 36 d'appui au sol, tels que par exemple deux pieds à vérins, distincts de ceux de la baie informatique 12 et destinés à être disposés sur la seconde dalle 26, dans l'espace disponible laissé entre la face arrière 16 de la baie 12 et l'extrémité libre de la seconde dalle 26.

D'une façon générale, les moyens de positionnement amovible permettent au dispositif de refroidissement 28 d'être interchangeable sur la baie informatique 12, c'est-à-dire de pouvoir être facilement positionné contre la face arrière 16 et facilement retiré. La baie informatique 12 peut ainsi être une baie standard contre laquelle vient se positionner un dispositif de refroidissement spécifique indépendant et interchangeable.

Lorsque ces moyens de positionnement amovible comportent les pieds à vérins 36, cela permet en outre au cadre porteur 30 de supporter intégralement le poids de la porte arrière 32 et d'alléger d'autant la charge supportée par la baie informatique 12. Comme il est par ailleurs possible de disposer ces pieds à vérins 36 sur la seconde dalle 26, l'encombrement général de l'installation informatique 10 reste le même.

Les moyens de refroidissement d'air prévus dans l'épaisseur de la porte arrière 32 comportent par exemple un échangeur de chaleur air/eau 38, et des ventilateurs 40 répartis sur la surface de la porte arrière 32 pour attirer la quantité d'air ayant circulé sur les composants électriques de puissance de la baie informatique 12 vers l'extérieur de celle-ci.

Pour le bon fonctionnement de ces moyens de refroidissement d'air, le dispositif de refroidissement 28 comporte en outre des premiers moyens 42 de raccordement de l'échangeur de chaleur air/eau 38 à une alimentation externe 44 en eau froide et des seconds moyens 46 de raccordement de l'échangeur de chaleur air/eau 38 à une évacuation externe 48 d'eau chaude ayant circulé dans cet échangeur.

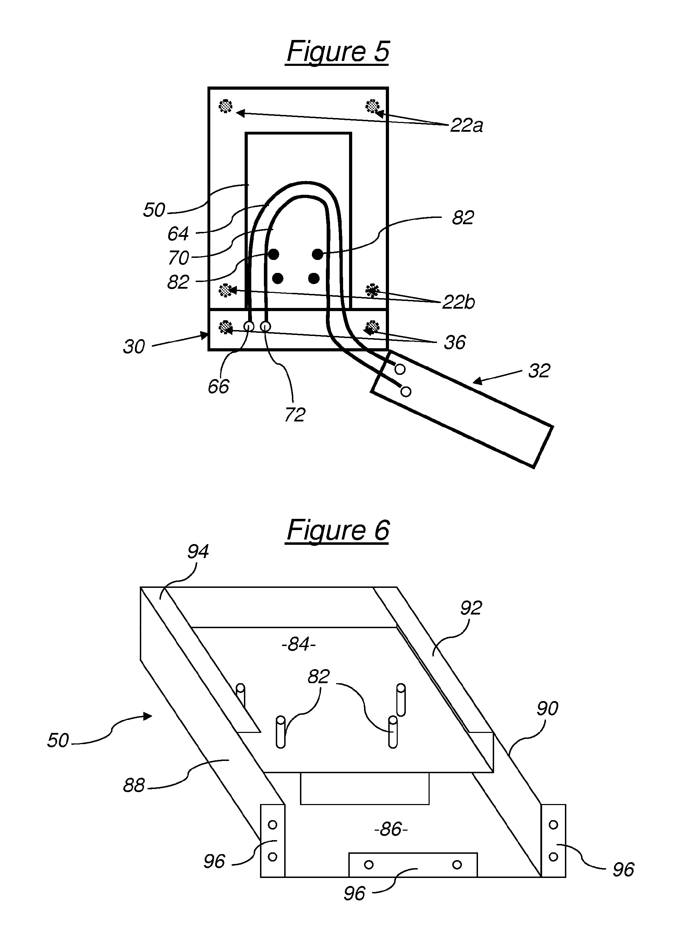

Puisque l'échangeur de chaleur air/eau 38 est disposé dans la porte arrière 32 qui est mobile, alors que l'alimentation externe 44 et l'évacuation externe 48 sont fixes et raccordées au sol, les moyens de raccordement 42 et 46 prévoient avantageusement l'utilisation de tuyaux flexibles. Pour éviter que ces tuyaux flexibles ne soient abîmés ou pincés lors de l'ouverture ou de la fermeture de la porte arrière 32, le dispositif de refroidissement 28 représenté sur la figure 1 comporte en outre un plateau 50 de réception et de guidage des tuyaux flexibles d'alimentation et d'évacuation, fixé en partie inférieure du cadre porteur 30 et destiné à s'insérer sous la baie informatique 12 entre le fond de cette baie et le sol, c'est-à-dire les dalles 24 et 26, sur lequel elle est posée à l'aide des pieds à vérins 22a et 22b. Ce plateau de réception et de guidage 50 sera détaillé en référence aux figure 5 et 6.

La figure 2 illustre l'encombrement général de l'installation informatique 10. Comme cela a été indiqué précédemment, la baie informatique 12 a une largeur correspondant à la largeur d'une dalle et une profondeur inférieure à deux dalles. Il a été vu que le dispositif de refroidissement 28 décrit précédemment n'ajoute pas d'encombrement en profondeur à l'installation informatique 10, du fait que les pieds à vérins 36 de son cadre porteur 30 peuvent être positionnés sur la seconde dalle 26. Il n'ajoute pas non plus d'encombrement en largeur, de sorte que l'encombrement général E de l'installation informatique 10 reste de quatre dalles : deux dalles de positionnement 24, 26 et deux dalles de maintenance 52 et 54.

C'est encombrement E est le même que celui des deux autres installations informatiques 10' et 10" représentées sur la figure 2, qui pourtant ne sont pas munies du dispositif de refroidissement 28. En outre, le dispositif de refroidissement 28 n'encombre pas l'espace intérieur de la baie informatique 12, de sorte que celle-ci a toujours une capacité de 42 U utiles uniquement dédiés à l'accueil des équipements informatiques.

Comme on aussi peut le remarquer sur cette figure 2, les installations informatiques 10, 10', 10" sont disposées côte à côte dans la salle informatique. Malgré ce positionnement, la porte arrière 32 du dispositif de refroidissement 28 de l'installation informatique 10 doit toujours pouvoir être ouverte à 180° afin de permettre la maintenance des équipements informatiques intégrés dans la baie 12 et l'accès à l'espace de câblage 34. Elle ne doit cependant pas entrer en collision avec l'installation mitoyenne.

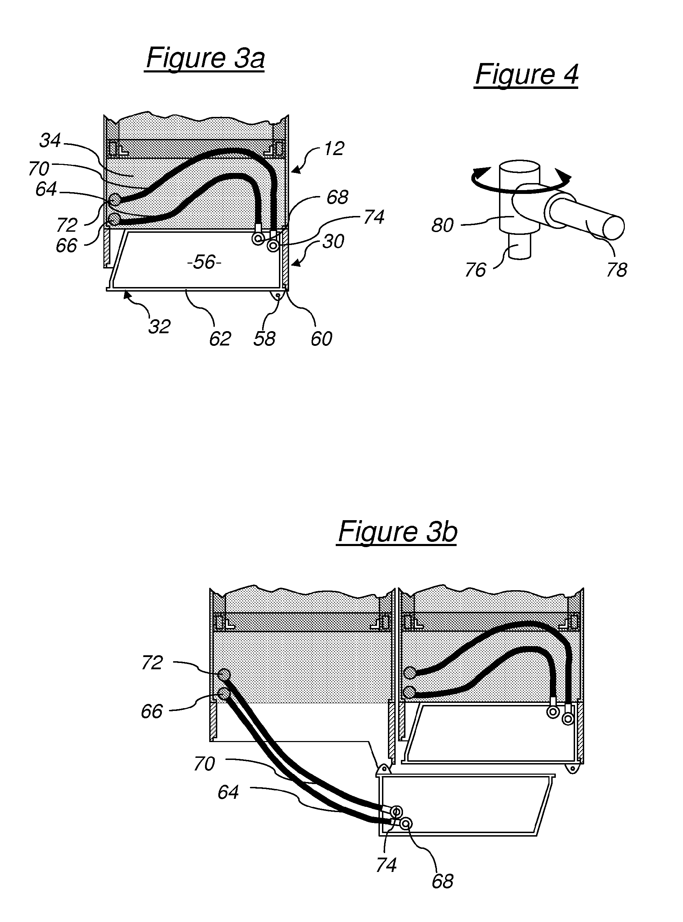

C'est pourquoi, un système de charnière déportée peut être utilisé, comme représenté sur la figure 3a en position fermée de la porte arrière 32 et sur la figure 3b en position ouverte de la porte arrière 32.

La figure 3a représente partiellement l'installation informatique 10 dans sa partie arrière, en vue de dessus. Sur cette figure, le cadre porteur 30 est positionné contre la face arrière 16 de la baie informatique 12. La porte arrière 32 est en position fermée et son volume intérieur 56 contenant les moyens de refroidissement est entièrement logé dans le volume intérieur du cadre porteur 30 : pour ce faire, l'extrémité libre de la porte arrière 32 est avantageusement biseautée dans son épaisseur.

La porte arrière 32 est montée pivotante sur le cadre porteur 30 à l'aide d'une charnière 58 dont l'axe de rotation vertical est situé sur une face extérieure 60 du cadre porteur 30 correspondant à une face extérieure 62 de la porte arrière 32. Ces faces extérieures 60 et 62 sont disposées du côté de l'ouverture de la porte arrière 32.

Sur cette figure 3a, les moyens de raccordement 42 et 46 de l'échangeur de chaleur air/eau 38 sont également représentés.

Les premiers moyens 42 de raccordement à l'alimentation externe 44 en eau froide comportent un premier tuyau flexible 64 fixé, à une extrémité, à un dispositif 66 de raccordement à l'alimentation externe 44 situé dans l'espace de câblage 34 et, à son autre extrémité, à un dispositif 68 de raccordement à l'échangeur de chaleur air/eau 38 situé dans la porte arrière 32.

Les seconds moyens 46 de raccordement à l'évacuation externe 48 d'eau chaude comportent un second tuyau flexible 70 fixé, à une extrémité, à un dispositif 72 de raccordement à l'évacuation externe 48 situé dans l'espace de câblage 34 et, à son autre extrémité, à un dispositif 74 de raccordement à l'échangeur de chaleur air/eau 38 situé dans la porte arrière 32.

De façon optionnelle, les dispositifs de raccordement 68 et 74 sont reliés à l'échangeur de chaleur air/eau 38 par l'intermédiaire d'une vanne classique à voies multiples (non représentée), par exemple à trois voies, pour la régulation de l'alimentation en eau froide et donc pour la régulation des moyens de refroidissement.

Sur la figure 3b, la porte arrière 32 est représentée en position ouverte à 180°. Grâce au système de charnière déportée, son ouverture n'est pas gênée par l'installation mitoyenne.

On remarque aussi que sur cette figure 3b, la position des tuyaux flexibles 64 et 70 n'est pas la même que sur la figure 3a. Ils sont tendus, du fait de l'ouverture à 180° de la porte arrière 32. C'est pourquoi on utilise de préférence un système à pivot pour les dispositifs de raccordement 68 et 74, et également éventuellement pour les dispositifs de raccordement 66 et 72.

Ce système à pivot est représenté sur la figure 4. Selon ce système, un premier tuyau rigide 76 est connecté à un second tuyau flexible 78 à l'aide d'un joint de raccordement 80 en forme de T dont la branche supérieure est montée coaxialement sur le premier tuyau rigide 76. Ainsi, le système à pivot des dispositifs de raccordement 66, 68, 72 et 74 s'adapte au mouvement des tuyaux flexibles 64 et 70 lors de l'ouverture ou de la fermeture de la porte arrière 32.

Par ailleurs, la dimension des tuyaux flexibles 64 et 70 est calculée en fonction de la longueur nécessaire lorsque la porte arrière 32 est complètement ouverte à 180°. Ainsi, lorsque la porte arrière 32 est fermée, l'encombrement des tuyaux flexibles 64 et 70 pose problème. En outre, leur diamètre leur donne un rayon de courbure important. Il est donc intéressant d'envisager de guider leur mouvement lors de l'ouverture ou de la fermeture de la porte arrière 32. C'est la fonction du plateau de réception et de guidage 50 représenté sur les figures 5 et 6 dans un mode de réalisation particulier de l'invention.

Comme représenté sur la figure 5, le plateau de réception et de guidage 50 est fixé en partie inférieure du cadre porteur 30 et est complètement intégré, dans l'espace occupé par la baie informatique 12, entre celle-ci et le sol. En variante, le plateau de réception et de guidage 50 pourrait être fixé à la baie informatique 12.

C'est dans ce plateau 50 que viennent se loger les tuyaux flexibles 64 et 70. De façon optionnelle, le plateau 50 est muni de moyens 82 de guidage des tuyaux flexibles 64 et 70 qui contraignent les déformations et les mouvements de ces tuyaux flexibles. Ces moyens de guidage 82 peuvent prendre la forme de pions de guidage.

On notera également que dans le mode de réalisation illustré par la figure 5, les dispositifs de raccordement 66 et 72 sont disposés sur le cadre porteur 30 au lieu d'être disposés dans l'espace de câblage 34, ce qui améliore l'autonomie du dispositif de refroidissement 28.

Le plateau de réception et de guidage 50 est représenté schématiquement en perspective sur la figure 6. Dans un mode de réalisation de l'invention, il comporte deux supports horizontaux superposés 84 et 86, l'un (84 ou 86) pour recevoir le premier tuyau flexible 64, l'autre (86 ou 84) pour recevoir le second tuyau flexible 70. Ainsi, les deux tuyaux flexibles ne se gênent pas entre eux lors de leurs déformations respectives. Quatre pions de guidage 82 sont représentés sur le support horizontal supérieur 84. De même, quatre pions de guidage 82, non visibles sur cette figure, peuvent être prévus sur le support horizontal inférieur 86.

En outre, les canaux réalisés par les bords latéraux verticaux 88, 90 du plateau 50 et deux rabats supérieurs 92, 94 de ces bords latéraux obligent les tuyaux flexibles 64 et 70 à s'enrouler naturellement.

Enfin, on notera que ce plateau de réception et de guidage 50 est muni de moyens 96 de fixation au cadre porteur 30, par exemple par vissage.

Il apparaît clairement qu'un dispositif de refroidissement d'une baie informatique 12 tel que décrit précédemment permet de le rendre interchangeable et de le positionner contre des baies informatiques standard sans contrainte particulière sur celles-ci.

En outre, bien que ce dispositif de refroidissement puisse comporter un échangeur de chaleur air/au, une batterie de ventilateurs, une vanne d'alimentation à voies multiples, des tuyaux flexibles, l'encombrement général de l'installation informatique comportant un tel dispositif de refroidissement n'est pas augmenté et la composition du dispositif de refroidissement n'a pas d'influence sur la structure de la baie informatique qui le reçoit.

Grâce à ce dispositif de refroidissement, il est non seulement possible d'obtenir un rapport de densité en équipement informatique maximal de 29 U/m², mais aussi d'évacuer jusqu'à 40 kW grâce à l'échangeur de chaleur air/eau. Cette solution est donc optimale en termes d'occupation de la salle informatique et d'efficacité/coûts de refroidissement.

Enfin, grâce à l'interchangeabilité des dispositifs de refroidissement des baies informatiques dans la salle informatique, cela permet une grande souplesse dans les évolutions possibles des équipements informatiques de cette salle.

## Revendications

1. Dispositif de refroidissement (28) d'une baie informatique (12) munie d'une face arrière (16) comportant une zone d'évacuation (18), vers l'extérieur de la baie, d'air ayant circulé sur des composants électriques de puissance (20₁, ..., 20ᵢ, ..., 20ₙ) disposés à l'intérieur de cette baie informatique (12), comportant une porte arrière (32) dans l'épaisseur de laquelle sont disposés des moyens (38, 40) de refroidissement d'air incluant au moins un échangeur (38) de chaleur air/eau, comportant en outre des premiers moyens (42) de raccordement à une alimentation externe (44) en eau froide et des seconds moyens (46) de raccordement à une évacuation externe (48) d'eau chaude ayant circulé dans l'échangeur (38) de chaleur air/eau, **caractérisé en ce qu'**il comporte en outre un cadre porteur (30) sur lequel la porte arrière (32) est montée, conformé pour entourer la zone d'évacuation d'air (18) de la baie informatique (12), et des moyens (36) de positionnement amovible du cadre porteur (30) contre la face arrière (16) de la baie informatique (12), et **en ce que** :
- les premiers moyens de raccordement (42) comportent un tuyau flexible (64) fixé, à une extrémité, à un dispositif (66) de raccordement à l'alimentation externe (44) et, à son autre extrémité, à un dispositif (68) de raccordement pivotant à l'échangeur (38) de chaleur air/eau,
- les seconds moyens de raccordement (46) comportent un tuyau flexible (70) fixé, à une extrémité, à un dispositif (72) de raccordement à l'évacuation externe (48) et, à son autre extrémité, à un dispositif (74) de raccordement pivotant à l'échangeur (38) de chaleur air/eau, et
- un plateau (50) de réception et de guidage des tuyaux flexibles (64, 70) d'alimentation et d'évacuation est fixé en partie inférieure du cadre porteur (30) et est destiné à s'insérer sous la baie informatique (12), entre le fond de la baie informatique (12) et le sol sur lequel elle est posée à l'aide de moyens d'appui (22a, 22b).

2. Dispositif de refroidissement (28) selon la revendication 1, dans lequel le cadre porteur (30) comporte des moyens (36) autonomes d'appui au sol, distincts de ceux (22a, 22b) de la baie informatique (12).

3. Dispositif de refroidissement (28) selon la revendication 1 ou 2, dans lequel la porte arrière (32) est montée pivotante sur le cadre porteur (30) à l'aide d'une charnière (58) dont l'axe de rotation vertical est situé sur une face extérieure (60, 62) du cadre porteur (30) et de la porte arrière (32), du côté de l'ouverture de la porte.

4. Dispositif de refroidissement (28) selon l'une quelconque des revendications 1 à 3, dans lequel les dispositifs (66, 72) de raccordement à l'alimentation externe (44) et à l'évacuation externe (48) sont disposés sur le cadre porteur (30) et les dispositifs (68, 74) de raccordement pivotant à l'échangeur (38) de chaleur air/eau sont disposés dans la porte arrière (32).

5. Dispositif de refroidissement (28) selon l'une quelconque des revendications 1 à 4, dans lequel le plateau de réception (50) est à au moins deux supports horizontaux superposés (84, 86).

6. Dispositif de refroidissement (28) selon l'une quelconque des revendications 1 à 5, dans lequel des moyens (82) de guidage des tuyaux flexibles (64, 70), notamment des pions de guidage, sont disposés dans le plateau de réception (50).

7. Dispositif de refroidissement (28) selon l'une quelconque des revendications 1 à 6, dans lequel les moyens (38, 40) de refroidissement d'air disposés dans l'épaisseur de la porte arrière (32) comportent une pluralité de ventilateurs (40) pour attirer l'air ayant circulé sur les composants électriques de puissance (20₁, ..., 20ᵢ, ..., 20ₙ) vers l'extérieur de la baie informatique (12).

8. Installation informatique (10) comportant une baie informatique (12) munie d'une face arrière (16) comportant une zone d'évacuation (18), vers l'extérieur de la baie, d'air ayant circulé à travers des composants électriques de puissance (20₁, ..., 20ᵢ, ..., 20ₙ) disposés à l'intérieur de cette baie informatique (12), et un dispositif de refroidissement (28) selon l'une quelconque des revendications 1 à 7.

## Patentansprüche

1. Vorrichtung (28) zum Kühlen eines Computer-Racks (12), das mit einer hinteren Fläche (16) versehen ist, die einen Bereich (18) zum Ablassen von Luft, die an innerhalb dieses Computer-Racks (12) angeordneten elektrischen Leistungsbauteilen (20₁, ..., 20ᵢ, ..., 20ₙ) in Umlauf war, zum Außenbereich des Racks aufweist, mit einer hinteren Tür (32), in deren Dicke Mittel (38, 40) zum Kühlen von Luft angeordnet sind, die zumindest einen Luft/Wasser-Wärmetauscher (38) umfassen, und ferner mit ersten Mitteln (42) zum Anschließen an eine äußere Kaltwasserversorgung (44) und mit zweiten Mitteln (46) zum Anschließen an einen äußeren Ablass (48) von Warmwasser, das in dem Luft/Wasser-Wärmetauscher (38) in Umlauf war, **dadurch gekennzeichnet, dass** sie ferner einen Halterahmen (30) aufweist, an dem die hintere Tür (32) angebracht ist und der so ausgebildet ist, dass er den Luftablassbereich (18) des Computer-Racks (12) umgibt, sowie Mittel (36) zur abnehmbaren Anordnung des Halterahmens (30) an der hinteren Fläche (16) des Computer-Racks (12), und dass:
- die ersten Anschlussmittel (42) einen Schlauch (64) aufweisen, der an einem Ende an einer Vorrichtung (66) zum Anschließen an die Außenversorgung (44) und an seinem andere Ende an einer Vorrichtung (68) für das schwenkbare Anschließen an den Luft/Wasser-Wärmetauscher (38) befestigt ist,
- die zweiten Anschlussmittel (46) einen Schlauch (70) aufweisen, der an einem Ende an einer Vorrichtung (72) zum Anschließen an den Außenablass (48) und an seinem anderen Ende an einer Vorrichtung (74) zum schwenkbaren Anschließen an den Luft/Wasser-Wärmetauscher (38) befestigt ist, und
- eine Platte (50) für die Aufnahme und Führung des Versorgungs- und Ablassschlauchs (64, 70) im unteren Teil des Halterahmens (30) befestigt und dazu vorgesehen ist, unterhalb des Computer-Racks (12) zwischen der Unterfläche des Computer-Racks (12) und dem Boden, auf dem es mit Stützmitteln (22a, 22b) aufgestellt ist, eingesetzt zu werden.

2. Kühlvorrichtung (28) nach Anspruch 1, bei der der Halterahmen (30) eigenständige Bodenabstützmittel (36) aufweist, die von den Stützmitteln (22a, 22b) des Computer-Racks (12) verschieden sind.

3. Kühlvorrichtung (28) nach Anspruch 1 oder 2, bei der die hintere Tür (32) mit einem Gelenk (58), dessen senkrechte Drehachse auf der Seite der Türöffnung an einer Außenfläche (60, 62) des Halterahmens (30) und der hinteren Tür (32) liegt, schwenkbar am Halterahmen (30) angebracht ist.

4. Kühlvorrichtung (28) nach einem der Ansprüche 1 bis 3, bei der die Vorrichtungen (66, 72) zum Anschließen an die Außenversorgung (44) und zum Anschließen an den Außenablass (48) am Halterahmen (30) angeordnet sind und die Vorrichtungen (68, 74) für den schwenkbaren Anschluss an den Luft/Wasser-Wärmetauscher (38) in der hinteren Tür (32) angeordnet sind.

5. Kühlvorrichtung (28) nach einem der Ansprüche 1 bis 4, bei der die Aufnahmeplatte (50) mit mindestens zwei waagerecht übereinanderliegenden Haltern (84, 86) ausgebildet ist.

6. Kühlvorrichtung (28) nach einem der Ansprüche 1 bis 5, bei der in der Aufnahmeplatte (50) Mittel (82) zur Führung der Schläuche (64, 70), insbesondere Führungsstifte angeordnet sind.

7. Kühlvorrichtung (28) nach einem der Ansprüche 1 bis 6, bei der die in der Dicke der hinteren Tür (32) angeordneten Luftkühlmittel (38, 40) mehrere Lüfter (40) umfassen, um die Luft, die an den elektrischen Leistungsbauteilen (20₁, ..., 20ᵢ, ..., 20ₙ) in Umlauf war, zum Außenbereich des Computer-Racks (12) anzuziehen.

8. EDV-Anlage (10), mit einem Computer-Rack (12), das mit einer hinteren Fläche (16) versehen ist, die einen Bereich (18) zum Ablassen von Luft, die durch innerhalb dieses Computer-Racks (12) angeordneten elektrischen Leistungsbauteilen (20₁, ..., 20ᵢ, ..., 20ₙ) in Umlauf war, zum Außenbereich des Racks aufweist, und mit einer Kühlvorrichtung (28) nach einem der Ansprüche 1 bis 7.

## Claims

1. Cooling device (28) of a computer rack (12) equipped with a back panel (16) comprising an evacuation zone (18), toward the exterior of the rack, of air having circulated over electric power components (20₁, ...,20₁ ...,20ₙ) arranged within this computer rack (12), comprising a rear door (32) in the thickness of which are arranged air cooling means (38, 40) including at least one air/water heat exchanger (38), further comprising first connection means (42) to an external supply (44) of cold water and second connection means (46) to an external evacuation (48) of hot water having circulated in the air/water heat exchanger (38), **characterized in that** it further comprises a supporting frame (30) on which the rear door (32) is mounted, molded to surround the air evacuation zone (18) of the computer rack (12), and removable positioning means (36) of the supporting frame (30) against the back panel (16) of the computer rack (12), and **in that**:
- the first connection means (42) comprise a flexible tube (64) attached, at one extremity, to a connection device (66) to the external supply (44) and, at its other extremity, to a pivoting connection device (68) to the air/water heat exchanger (38),
- the second connection means (46) comprise a flexible tube (70) attached, at one extremity, to a connection device (72) to the external evacuation (48) and, at its other extremity, to a pivoting connection device (74) to the air/water heat exchanger (38), and
- a plate (50) for receiving and guiding flexible tubes (64,70) of supply and evacuation is fixed in the lower part of the supporting frame (30) and is designed to be inserted under the computer rack (12), between the base of the computer rack (12) and the floor on which it is stood by means of the support means (22a, 22b).

2. Cooling device (28) according to claim 1, wherein the supporting frame (30) comprises autonomous means (36) of floor support, separate from those (22a, 22b) of the computer rack (12).

3. Cooling device (28) according to claim 1 or 2, wherein the back panel (32) is mounted pivoting on the supporting frame (30) by means of a hinge (58) whose vertical rotation axis is located on an exterior face (60,62) of the supporting frame (30) and the rear door (32), on the side of the opening of the door.

4. Cooling device (28) according to any one of claims 1 to 3, wherein the connection devices (66, 72) to the external supply (44) and to the external evacuation (48) are arranged on the supporting frame (30) and the pivoting connection devices (68, 74) to the air/water heat exchanger (38) are arranged in the rear door (32).

5. Cooling device (28) according to any one of claims 1 to 4 wherein the reception plate (50) has at least two overlaid horizontal supports (84, 86).

6. Cooling device (28) according to any one of claims 1 to 5, when guiding means (82) of the flexible tubes (64, 70), notably guide pins, are arranged in the reception plate (50).

7. Cooling device (28) according to any one of claims 1 to 6, wherein the air cooling means (38, 40) arranged in the thickness of the rear door (32) comprise a plurality of fans (40) to draw the air having circulated over the electric power components (20₁,..., 20₁, ..., 20ₙ) toward the exterior of the computer rack (12).

8. Computer installation(10) comprising a computer rack (12) equipped with a back panel (16) comprising an evacuation zone (18), toward the exterior of the rack, of air having circulated over electric power components (20₁,..., 20₁, ..., 20ₙ) arranged within this computer rack (12), and a cooling device (28) according to any one of claims 1 to 7.
